# FASCICULE DE BREVET EUROPEEN

(11) **EP 3 198 690 B1**
(45) Date de publication et mention de la délivrance du brevet: **27.05.2020**
(21) Numéro de dépôt: 15785057.9
(22) Date de dépôt: 25.09.2015
(51) Int. Cl.: H01S 5/12, H01S 5/22, H01S 5/042, H01S 5/20, H01S 5/227

(54) **PROCÉDÉ D'ÉLABORATION D'UNE STRUCTURE RÉSONANTE D'UN LASER À SEMI-CONDUCTEUR À CONTRE-RÉACTION RÉPARTIE**
VERFAHREN ZUR HERSTELLUNG EINER RESONANZSTRUKTUR EINES HALBLEITERLASERS MIT VERTEILTER RÜCKKOPPLUNG
METHOD FOR PRODUCING A RESONANT STRUCTURE OF A DISTRIBUTED-FEEDBACK SEMICONDUCTOR LASER

(30) Priorité: 26.09.2014 FR 1402166
(43) Date de publication de la demande: 02.08.2017
(73) Titulaire: Thales, 92400 Courbevoie (FR)
(72) Inventeur: CARRAS, Mathieu, 91767 Palaiseau (FR); MAISONS, Grégory, 78150 Le Chesnay (FR); SIMOZRAG, Bouzid, 91767 Palaiseau (FR)
(74) Mandataire: Joubert, Cécile
(86) Numéro de dépôt international: PCT/EP2015/072099
(87) Numéro de publication internationale: WO 2016/046368

(56) Documents cités:
- US-A- 4 712 609
- US-A- 4 902 644
- US-A- 5 624 529
- US-A1- 2003 008 426
- US-A1- 2007 183 470
- US-A1- 2007 253 456
- US-A1- 2009 245 298
- US-A1- 2011 051 768
- US-A1- 2014 251 949
- US-B1- 6 381 258
- US-B1- 6 395 573

## Description

L'invention se situe dans le domaine des lasers à cascade quantique, et, plus particulièrement, des lasers à semi-conducteur à contre-réaction répartie.

Plus précisément, l'invention concerne un procédé d'élaboration d'une structure résonante d'un laser à semi-conducteur à contre-réaction répartie selon une technologie des réseaux de surface métallisés.

On entend par laser à cascade quantique, ou QCL, acronyme pour « *Quantum Cascade Laser* » un laser à semi-conducteur pouvant émettre un photon dans un domaine de longueurs d'ondes allant du moyen infrarouge au lointain infrarouge, l'émission laser étant obtenue par transitions inter-sous-bandes d'une structure à confinement quantique.

On entend par laser à semi-conducteur à contre-réaction répartie, ou DFB pour « Distributed FeedBack », en langue anglaise, un laser à semi-conducteur mettant en oeuvre un guide optique et possédant un réseau permettant une contre-réaction répartie, celui-ci pouvant être métallique de surface. (voir par exemple US6,381,258 B1)

La technologie des lasers à semi-conducteurs à contre-réaction répartie possédant un réseau métallique de surface permet notamment de réaliser un couplage par le gain. Il s'agit de réaliser la croissance de toutes les couches constitutives de la structure résonante et de graver ensuite un réseau de diffraction dans le guide supérieur puis de métalliser.

Une méthode d'élaboration d'une structure résonante d'un laser semi-conducteur à contre-réaction répartie selon la technologie des réseaux de surface métallisés selon l'art antérieur (voir par exemple US2007/0183470 A1) consiste à réaliser le réseau sur la surface supérieure d'un empilement de couches comprenant des matériaux semi-conducteurs et ensuite à réaliser des cavités permettant de définir un ruban.

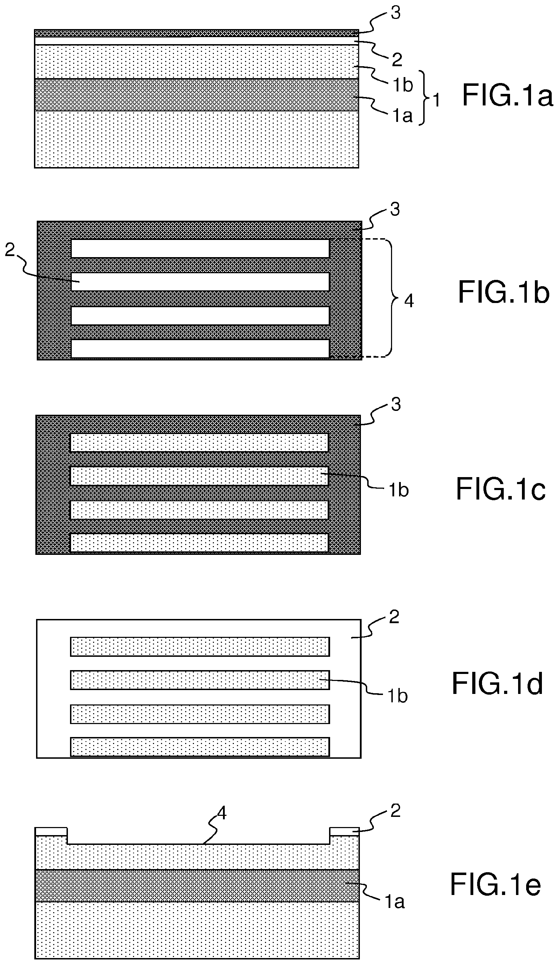

Les étapes de réalisation d'une structure résonante d'un laser à semi-conducteur à contre-réaction répartie selon la technologie des réseaux de surface métallisés selon l'art antérieur sont détaillées sur les figures 1a à 1m.

Dans une première étape, la surface supérieure d'un empilement multicouche 1 comprenant des matériaux semi-conducteurs 1a; 1b est entièrement recouverte d'une couche comprenant un matériau isolant électrique 2 puis enduite d'une couche provisoire 3.

La couche isolante électrique 2 sert de masque dur pour la gravure sèche des réseaux
En l'espèce, la couche provisoire 3 comprend du PMMA, acronyme pour poly(methylméthacrylate).

Le motif du réseau de diffraction 4 est ensuite inscrit dans la couche provisoire 3 par application d'un faisceau d'électrons, le faisceau d'électrons reproduisant le motif du réseau 4 désiré sur la couche provisoire 3.

La figure 1a représente une vue de profil de l'empilement 1 après la première étape.

La deuxième étape de développement consiste en l'immersion de la surface recouverte de PMMA dans un solvant de manière à retirer toutes les zones de la surface recouvertes de PMMA ayant été soumises au faisceau d'électrons.

La figure 1b représente une vue de dessus de la surface supérieure de l'empilement 1 après la deuxième étape de développement. La surface de l'empilement 1 comprend une première zone comprenant le matériau provisoire 3 et des deuxièmes zones sur lesquelles le matériau provisoire 3 a été retiré laissant apparaître la couche de matériau diélectrique 2, les deuxièmes zones sans le matériau provisoire 3 reproduisant le motif du réseau de diffraction 4.

La figure 1c représente une vue de dessus de la surface supérieure de l'empilement 1 après la troisième étape de gravure du matériau diélectrique 2. En l'espèce, la méthode de gravure est une gravure par ion réactif ou RIE acronyme pour « Reactive Ion Etching », en langue anglaise, le plasma utilisé comprenant du CHF₃. Cette étape de gravure du matériau diélectrique 2 permet de faire réapparaître le matériau semi-conducteur 1b situé en surface de l'empilement 1. Les parties comprenant le matériau semi-conducteur 1b reproduisant le motif du réseau de diffraction 4.

La quatrième étape correspond au retrait du matériau provisoire 3 n'ayant pas encore été retiré. La surface de l'empilement 1 est donc immergée dans un solvant comprenant de l'acétone.

La surface de l'empilement 1 laisse apparaître le motif du réseau 4 : le matériau semi-conducteur 1b présentant le motif du réseau 4 et le matériau diélectrique 2 présentant le négatif du motif du réseau de diffraction 4, comme indiqué sur la figure 1d.

Dans une cinquième étape, le réseau 4 est gravé dans le matériau semi-conducteur 1b.

La figure 1e représente une vue de profil de l'empilement 1, la surface de l'empilement 1 étant gravée.

La sixième étape consiste au retrait du matériau diélectrique 2. En l'espèce le retrait est réalisé par immersion de la surface de l'empilement 1 dans un bain comprenant de l'acide fluorhydrique.

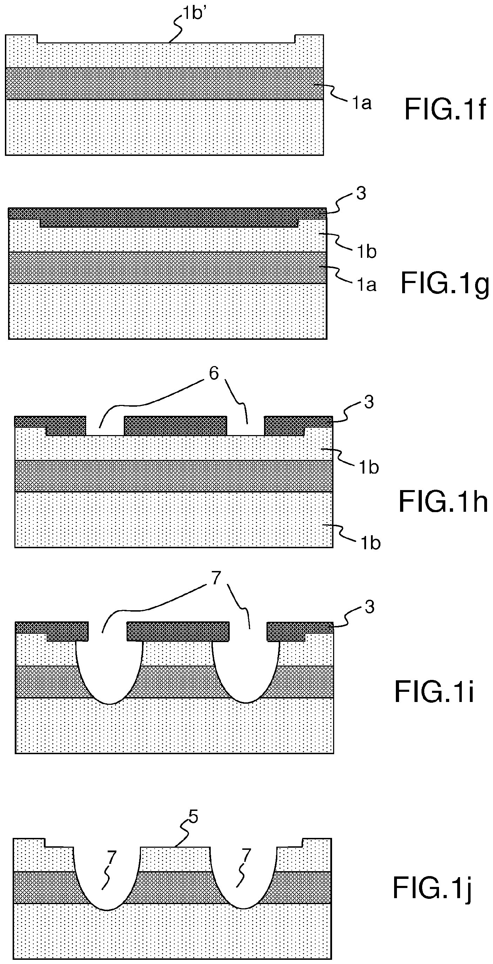

La figure 1f représente le profil de l'empilement 1, la surface de l'empilement 1 étant gravée et le matériau diélectrique 2 retiré.

La septième étape consiste en l'enduction de la surface de l'empilement 1 par une couche comprenant un matériau provisoire 3.

La figure 1g représente le profil de l'empilement 1 dont la surface est recouverte par une couche de matériau provisoire 3.

Une huitième étape consiste au retrait du matériau provisoire 3 par lithographie optique sur au moins deux zones 6 mettant à jour le semi-conducteur 1b de l'empilement 1.

La figure 1h présente l'empilement 1 après ouverture du matériau provisoire 3.

Dans une neuvième étape, l'empilement 1 est gravé chimiquement au niveau des deux zones 6 d'ouvertures du matériau provisoire 3 de manière à former au moins deux cavités 7. La méthode de gravure chimique permet en outre d'éviter que le motif du réseau 4 ne soit inscrit sur les flancs du ruban 5.

La figure 1i présente une vue de profil de l'empilement 1 après gravure chimique des cavités 7. Les cavités 7 s'étendent au-delà des deux zones 6 d'ouvertures. En effet, les cavités 7 s'étendent en partie en dessous du masque constitué par le matériau provisoire 3. Le ruban 5 est finalement plus étroit que le masque formé par la couche de matériau provisoire 3, la différence entre le masque et le ruban 5 étant difficilement contrôlable par l'opérateur.

Dans une dixième étape, le matériau provisoire 3 ayant servi de masque lors de la neuvième étape de gravure chimique est retiré par immersion de la surface de l'empilement 1 dans un solvant comprenant de l'acétone.

La figure 1j présente une vue de profil de l'empilement 1, la surface de l'empilement 1 présentant deux cavités 7 et un ruban 5 situé entre les deux cavités 7 sur lequel est gravé le réseau de diffraction 4.

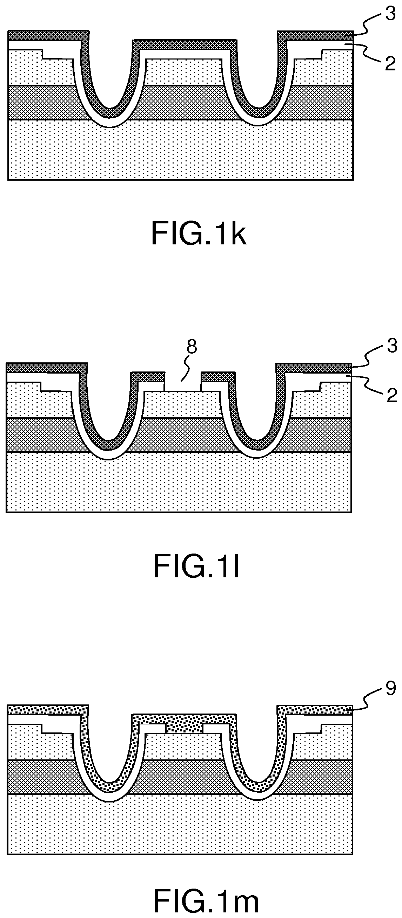

Dans une onzième étape, la surface de l'empilement 1 est entièrement recouverte d'une couche de matériau diélectrique 2 puis enduite d'une couche de matériau provisoire 3, comme représentée sur la figure 1k.

La couche isolante électrique 2 permet d'isoler l'empilement 1 de semi-conducteur du reste de la structure résonante, le matériau isolant électrique 2 pouvant être un dépôt de nitrure de silicium ou de silice.

Dans une douzième étape, une partie du matériau provisoire 3 et du matériau diélectrique 2 est retirée par lithographie optique et gravure RIE pour former une ouverture 8.

La figure 1l représente une vue de profil de l'empilement 1 après la formation de l'ouverture 8 de la couche de diélectrique 2 et de matériau provisoire 3. Autrement dit, la couche de matériau diélectrique 2 et la couche de matériau provisoire 3 recouvrent en partie le réseau de diffraction 4 gravé sur le ruban 5, ou, en d'autres termes, le réseau de diffraction 4 est partiellement recouvert par la couche de silice 2 et de matériau provisoire 3.

Dans une treizième étape, figure 1m, le matériau provisoire 3 est retiré et la surface de l'empilement 1 est recouverte d'une couche métallique 9 comprenant notamment de l'or.

Un inconvénient de cette méthode est le manque de reproductibilité lors de la formation du ruban 5 par gravure chimique.

La gravure chimique est une méthode ne permettant qu'une faible précision. La figure 1i met bien en évidence les difficultés que pose la méthode de gravure chimique pour réaliser le ruban 5. En effet l'empilement de matériau semi-conducteur 1a ; 1b est gravé au-delà des deux zones 6 prédéfinies par le masque de matériau provisoire 3, et ce, avec peu de contrôle de la part de l'opérateur.

Cet inconvénient est d'autant plus gênant lorsque l'on souhaite réaliser des guides d'ondes étroits. En effet, le risque est de graver complètement le ruban 5 présentant le réseau de diffraction 4 et de ne pas pouvoir obtenir de guide d'onde.

Un but de l'invention est de proposer un procédé d'élaboration reproductible d'une structure résonante d'un laser à semi-conducteur à contre-réaction répartie présentant un guide d'onde étroit de l'ordre de la dizaine de micromètres.

Selon un aspect de l'invention, il est proposé un procédé d'élaboration d'une structure résonante d'un laser à semi-conducteur à contre-réaction répartie, la structure résonante comprenant un empilement multicouche de matériaux semi-conducteurs, l'empilement multicouche présentant au moins deux cavités définissant un ruban sur la face supérieure de l'empilement, un réseau de diffraction étant disposé sur le ruban.

Le procédé comprend dans l'ordre :
- une première étape d'élaboration du ruban comprenant :
   - une première sous-étape de formation desdites cavités,
   - une deuxième sous-étape de recouvrement de la face supérieure de l'empilement par une couche de matériau diélectrique,
   - une troisième sous-étape de retrait d'une partie de la couche de matériau diélectrique entre lesdites cavités pour former une ouverture laissant apparaître une partie du matériau semi-conducteur et servant d'accès au contact électrique, la méthode de retrait étant spécifique du matériau diélectrique,
- une deuxième étape d'élaboration du réseau de diffraction à l'intérieur de l'ouverture sur le ruban comprenant :
   - une quatrième sous-étape de réalisation de bandes métalliques comprenant une couche métallique sur la face supérieure de l'empilement, les bandes métalliques servant de masque pour la gravure, les bandes représentant le négatif du motif du réseau de diffraction, et
   - une cinquième sous-étape de gravure sèche spécifique du matériau semi-conducteur.

L'élaboration du réseau de diffraction postérieurement à l'étape d'élaboration du ruban rend envisageable la préparation d'un stock d'empilement multicouche comprenant des matériaux semi-conducteurs présentant un ruban. Dans une dernière étape, il est alors possible d'inscrire un réseau de diffraction en fonction d'une longueur d'onde précise souhaitée.

On entend par ruban la bande de matériau semi-conducteur obtenue à la surface de l'empilement après la formation des cavités.

On entend par guide d'onde le ruban sur lequel est disposé le réseau de diffraction.

Avantageusement, le retrait d'au moins une partie du matériau diélectrique est réalisé par gravure sèche spécifique du matériau diélectrique.

Avantageusement, la première sous-étape de formation desdites cavités de la première étape d'élaboration dudit ruban est réalisée par gravure anisotrope.

Avantageusement, la couche de matériau diélectrique comprend de la silice ou du nitrure de silicium ou de l'oxyde d'aluminium ou du nitrure d'aluminium et la gravure sèche est réalisée avec un plasma comprenant du CHF₃.

Avantageusement, la gravure sèche spécifique du matériau semi-conducteur utilise un plasma comprenant du méthane.

La silice ou le nitrure de silicium sont des matériaux particulièrement appropriés : ils servent d'isolant électrique, ils permettent un fort contraste d'indice avec les matériaux semi-conducteurs constitutifs de l'empilement permettant ainsi un confinement du mode optique dans l'empilement multicouche de matériaux semi-conducteurs. Par ailleurs, la silice ou le nitrure de silicium sont insensibles à la gravure par ions réactif utilisant un plasma comprenant du CH₄ permettant une gravure sélective du matériau semi-conducteur lors de l'inscription du réseau de diffraction.

Avantageusement, la quatrième sous-étape de réalisation des bandes métalliques sur la face supérieure de l'empilement comprend :
- une première étape élémentaire de recouvrement de la face supérieure de l'empilement multicouche par un matériau provisoire,
- une deuxième étape élémentaire de retrait d'au moins une partie du matériau provisoire, le matériau provisoire restant reproduisant le négatif du motif du réseau de diffraction,
- une troisième étape élémentaire de dépôt d'une couche métallique sur l'ensemble de la face supérieure de l'empilement multicouche,
- une quatrième étape élémentaire de retrait du matériau provisoire recouvert par la couche métallique.

Avantageusement, le matériau provisoire est du poly (methylmethacrylate) ou PMMA.

Avantageusement, la couche métallique comprend deux sous-couches : une première sous-couche comprenant du titane servant de couche d'accroche et une deuxième sous-couche comprenant du platine.

Selon un autre aspect de l'invention, il est proposé une structure résonante de laser à semi-conducteur à contre-réaction répartie réalisée selon le procédé décrit précédemment dans lequel le réseau de diffraction est parfaitement centré sur la couche de diélectrique et présente un axe de symétrie de direction parallèle à la direction de l'empilement multicouche et passant par le milieu de l'ouverture.

Avantageusement, le réseau de diffraction est gravé sur le semi-conducteur uniquement à l'intérieur de l'ouverture de la couche de matériau diélectrique.

Avantageusement, la distance selon une direction perpendiculaire à la direction de l'empilement entre une extrémité du réseau de diffraction et la couche de matériau diélectrique est inférieure à 10 nm.

L'invention sera mieux comprise et d'autres avantages apparaîtront à la lecture de la description qui va suivre donnée à titre non limitatif, et, grâce aux figures annexées parmi lesquelles :
- les figures 1a à 1m représentent la structure résonante d'un laser à semi-conducteur à contre réaction répartie après différentes étapes d'un procédé d'élaboration selon l'art connu,
- les figures 2a à 2j représentent la structure résonante d'un laser à semi-conducteur à contre-réaction répartie après différentes étapes du procédé d'élaboration selon un aspect de l'invention,
- la photo 3 représente une image obtenue au microscope électronique à balayage d'un guide d'onde constitué d'un ruban sur lequel est gravé un réseau de diffraction selon un aspect de l'invention,
- la photo 4 représente un agrandissement de la zone encadrée sur la figure 3,
- la photo 5 représente une image obtenue au microscope électronique à balayage d'une coupe longitudinale selon un plan traversant le réseau de diffraction, et
- la photo 6 représente le dispositif final après toutes les étapes de fabrication.

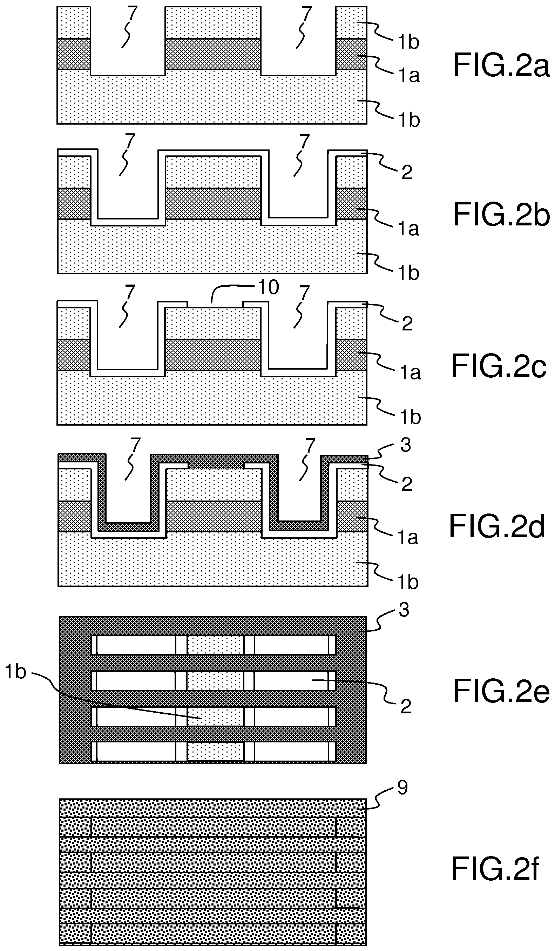

Le procédé d'élaboration d'une structure résonante d'un laser à semi-conducteur à contre-réaction répartie selon un aspect de l'invention est décrit sur les figures 2a à 2j qui représentent la structure résonante après différentes étapes du procédé selon l'invention.

Le principe du procédé repose sur une étape d'élaboration du réseau de diffraction par gravure sèche postérieurement à une étape de réalisation du guide d'onde.

La figure 2a représente un empilement 1 d'une multitude de couches comprenant des matériaux semi-conducteurs 1a, 1b préalablement usiné de manière à créer au moins deux cavités 7 et un ruban 5 situé entre les deux cavités 7. A cette étape du procédé, le ruban 5 ne présente pas encore de réseau de diffraction.

Typiquement, les matériaux semi-conducteurs utilisés comprennent de l'InP, de l'AlInAs ou du GaInAs.

Avantageusement, l'usinage est réalisé par gravure de manière à former des cavités 7. Préférentiellement, les cavités 7 sont de forme rectangulaire. Dans un mode de réalisation de l'invention, l'usinage est réalisé au moyen d'une gravure anisotrope, de manière à contrôler la largeur des cavités 7. La gravure anisotrope peut être une gravure sèche, par exemple une gravure ionique réactive (RIE). L'usinage par gravure anisotrope permet de contrôler avec précision la largeur du ruban 5 par rapport à un usinage réalisé au moyen d'une gravure isotrope.

La figure 2b représente l'empilement 1 usiné après recouvrement de la surface supérieure de l'empilement 1 par une couche de matériau diélectrique 2.

Le matériau isolant électrique 2 comprend avantageusement de la silice ou du Si₃N₄. Préférentiellement, le matériau isolant électrique 2 comprend de la silice permettant un fort contraste d'indice optique entre le matériau diélectrique 2 et l'empilement 1 comprenant les matériaux semi-conducteurs 1a, 1b permettant ainsi un confinement du mode optique dans l'empilement 1.

La figure 2c représente l'empilement 1 multicouche après ouverture 10 de la couche de silice 2, ou, en d'autres termes, après le retrait d'une partie de la silice 2 située sur le ruban 5.

L'ouverture 10 de la couche de silice 2 permet de faire apparaître le matériau semi-conducteur 1b. L'ouverture 10 de la couche de silice 2 permet de définir le réseau de diffraction et le contact électrique.

La figure 2d représente l'empilement 1 après recouvrement total de la surface supérieure de l'empilement 1 avec une couche de matériau provisoire 3, le matériau provisoire 3 servant de masque pour définir le motif du réseau de diffraction 4.

Avantageusement, le matériau provisoire 3 comprend du poly(methylméthacrylate) ou PMMA. Un faisceau d'électrons est appliqué à la surface du PMMA, le faisceau reproduisant le motif du réseau de diffraction 4 souhaité. Après une étape de développement, ou, autrement dit, d'immersion de la surface de PPMA 3 dans un solvant comprenant de l'acétone, toute la surface de matériau provisoire 3 ayant été soumise au faisceau d'électrons est rétirée.

La figure 2e représente une vue de dessus de l'empilement 1.

Le PMMA 3 restant à la surface de l'empilement 1 représente un négatif du motif du réseau de diffraction 4, gravé dans une étape ultérieure, ou, en d'autres termes, la partie sans PMMA est creusée par rapport à la partie avec PMMA, la partie creusée sans PMMA représente le motif du réseau de diffraction 4. La partie creusée sans PMMA met en évidence des premières zones laissant apparaître le matériau semi-conducteur 1b et des deuxièmes zones laissant apparaître le matériau isolant électrique 2, en l'espèce, la silice.

La figure 2f représente l'empilement 1 après dépôt d'une couche métallique 9. En l'espèce, la couche métallique 9 comprend deux sous-couches disposées l'une sur l'autre. La première sous-couche comprend avantageusement du titane servant de couche d'accroche et la deuxième sous-couche comprend avantageusement du platine afin de résister au plasma lors de la gravure sèche du matériau semi-conducteur.

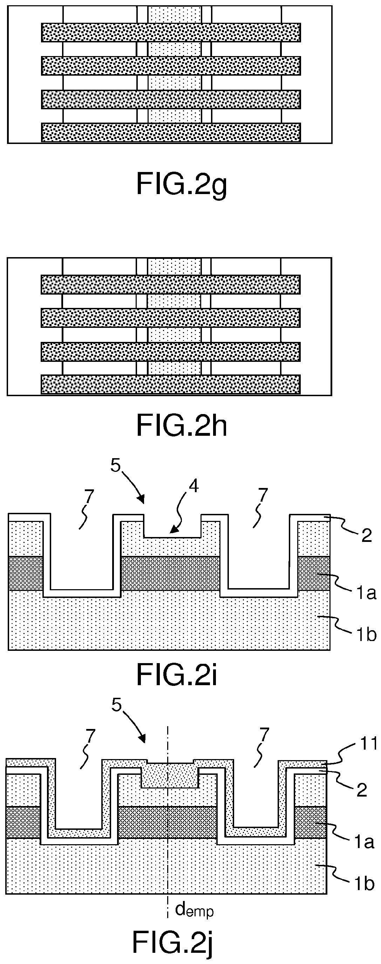

La figure 2g représente une vue de dessus de l'empilement 1 après immersion de la surface de l'empilement 1b dans un bain comprenant de l'acétone de manière à retirer le masque de PMMA 3. Tout le PMMA 3 recouvert de la couche métallique 9 est ainsi retiré, laissant apparaître la couche de matériau diélectrique 2 sous-jacente, en l'occurrence, la silice, et, le matériau semi-conducteur 1b.

La figure 2h représente la surface supérieure de l'empilement 1 après avoir réalisé une gravure sèche du matériau semi-conducteur 1b. En l'espèce, la gravure est une méthode de gravure par ion réactif ou RIE. Le plasma utilisé pour réaliser la gravure comprend avantageusement du méthane. La gravure ainsi réalisée est sélective et ne grave que le matériau semi-conducteur 1b sans graver la silice 2 ou la couche métallique 9.

La figure 2i est une vue de coupe de l'empilement 1 réalisée selon un plan parallèle à la direction de l'empilement d_{Emp}.

La figure 2j est une vue de coupe de l'empilement 1 réalisée selon un plan parallèle à la direction de l'empilement d_{Emp} et après dépôt d'une couche métallique 11. En l'espèce, la couche métallique 11 comprend trois sous-couches superposées. La première sous-couche comprend avantageusement du titane servant de couche d'accroche, la deuxième sous-couche comprend avantageusement du platine servant de barrière de diffusion à l'or qui constitue la troisième sous-couche. Le dépôt de la couche métallique 11 permet de remplir les créneaux du réseau de diffraction 4 dans le but d'obtenir une contre-réaction répartie et de réaliser un contact électrique.

Ce procédé de réalisation d'une structure résonante permet de réaliser des guides d'onde étroits de manière reproductible.

Par ailleurs, la structure résonante d'un laser réalisée selon l'invention présente certaines caractéristiques spécifiques du procédé de réalisation.

La figure 2j met en évidence un axe de symétrie de direction parallèle à la direction de l'empilement 1 et passant par le milieu du réseau de diffraction 4. En d'autres termes, le réseau de diffraction 4 est parfaitement centré sur l'ouverture 10 de la couche diélectrique 2. Cette caractéristique était difficilement réalisable avec le procédé de l'art antérieur tel que décrit précédemment du fait des aléas liés à la difficulté d'alignement entre les étapes de fabrication.

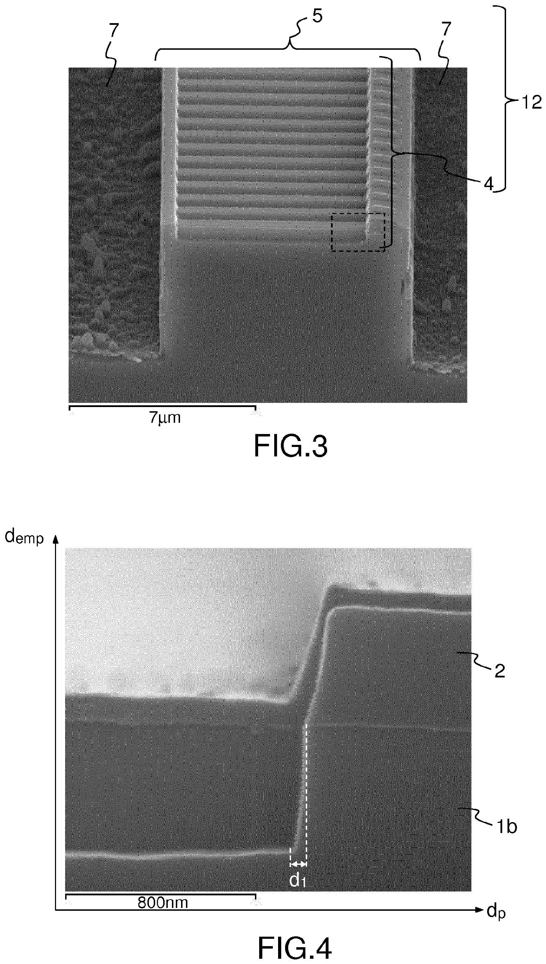

La figure 3 est une photo enregistrée à l'aide un microscope électronique à balayage représentant une vue de dessus d'une partie de la structure résonante. La figure 3 présente un guide d'onde 12 comprenant le ruban 5 sur lequel est gravé un réseau de diffraction 4 métallisé. La largeur du guide d'onde 12 est de l'ordre de la dizaine de micromètres. De part et d'autre du guide d'onde 12, les cavités 7 sont visibles.

La figure 4 est un agrandissement de l'encadré de la figure 3. Cet agrandissement permet de mettre en évidence une caractéristique de la structure obtenue par le procédé d'élaboration.

En effet, sur cette figure 4, le réseau de diffraction 4 est formé uniquement à l'intérieur de l'ouverture 10, ou, en d'autres termes, la couche de silice 2 ne recouvre pas une partie du réseau de diffraction 4 comme cela était le cas lors de la réalisation de la structure résonante selon l'art antérieur. Une distance d1 selon une direction perpendiculaire dₚ à la direction de l'empilement d_{Emp} entre une extrémité du réseau de diffraction 4 et la couche de silice 2 est inférieure à 10 nanomètres.

La sous-étape de recouvrement de la face supérieure de l'empilement 1 par une couche de matériau diélectrique 2 et la sous-étape de retrait d'une partie de la couche de matériau diélectrique 2 entre lesdites cavités 7 pour former une ouverture permettent la réalisation d'un écart entre une extrémité du réseau de diffraction 4 et une cavité selon la direction dₚ. La couche de matériau diélectrique 2 ainsi formée protège les parois latérales du ruban 5 lors d'une cinquième sous-étape de gravure sèche spécifique du matériau semi-conducteur. Sans cette protection, les parois latérales du ruban 5 pourraient être affectées par la gravure sèche de la cinquième sous-étape.

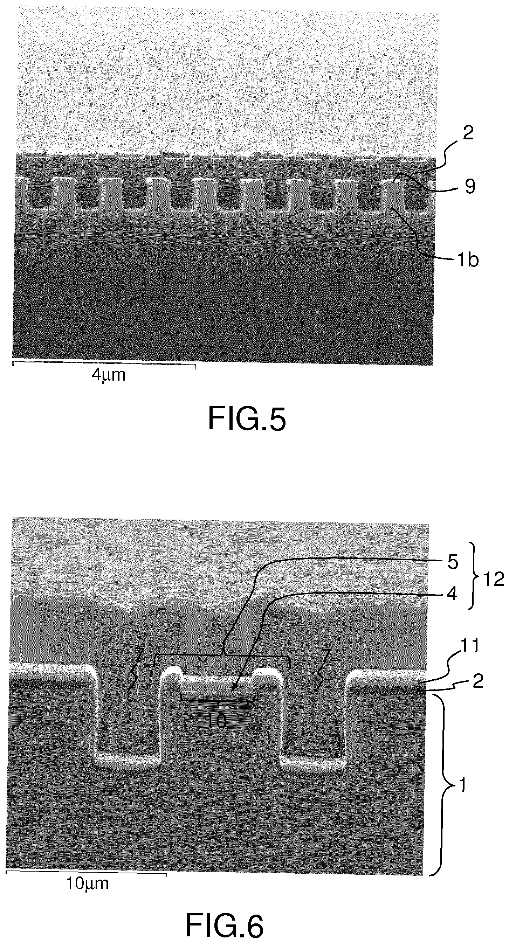

La figure 5 est une photo enregistrée à l'aide d'un microscope électronique à balayage représentant une vue de coupe selon la direction périodique du réseau de diffraction 4. Cette photo met en évidence les créneaux formés par le réseau de diffraction 4. Les creux comprennent le matériau semi-conducteur 1b gravé et la surface des crêtes comprend la couche métallique 9.

La figure 6 représente le dispositif final après toutes les étapes de réalisation. Cette zone met en évidence l'empilement 1 comprenant des matériaux semi-conducteurs 1a, 1b de type AlInAs ou GaInAs ou InP, les deux cavités 7 permettant de définir le ruban 5 sur lequel une ouverture 10 est formée et à l'intérieur de laquelle un réseau de diffraction 4 est gravé, l'ensemble formant le guide d'onde 12. Une couche métallique 11 recouvre l'ensemble de la structure. Le guide d'onde 12 formé à l'aide du procédé décrit précédemment a une largeur d'environ 8 micromètres.

## Revendications

1. Procédé d'élaboration d'une structure résonante d'un laser à semi-conducteur à contre-réaction répartie, la structure résonante comprenant un empilement (1) multicouche de matériaux semi-conducteurs (1a; 1b), l'empilement (1) multicouche présentant au moins deux cavités (7) définissant, entre les deux cavités, un ruban (5) sur la face supérieure de l'empilement (1), un réseau de diffraction (4) étant disposé sur le ruban (5) le procédé comprend dans l'ordre :
- une première étape d'élaboration du ruban (5) comprenant :
• une première sous-étape de formation desdites cavités (7),
• une deuxième sous-étape de recouvrement de la face supérieure de l'empilement (1) par une couche de matériau diélectrique (2),
• une troisième sous-étape de retrait d'une partie de la couche de matériau diélectrique (2) entre lesdites cavités (7) pour former une ouverture (10) laissant apparaître une partie du matériau semi-conducteur (1b) et servant d'accès au contact électrique, la méthode de retrait étant spécifique du matériau diélectrique (2),
- une deuxième étape d'élaboration du réseau de diffraction (4) à l'intérieur de l'ouverture (10) sur le ruban (5) comprenant :
• une quatrième sous-étape de réalisation de bandes métalliques comprenant une couche métallique (9) sur la face supérieure de l'empilement (1), les bandes métalliques servant de masque pour la gravure de la sous étape qui suit, les bandes représentant le négatif du motif du réseau de diffraction (4) que l'on souhaite produire, et
• une cinquième sous-étape de gravure sèche spécifique du matériau semi-conducteur (1b).

2. Procédé selon la revendication 1 dans lequel le retrait d'au moins une partie du matériau diélectrique (2) est réalisé par gravure sèche spécifique du matériau diélectrique.

3. Procédé selon l'une des revendications précédentes dans lequel la première sous-étape de formation desdites cavités (7) de la première étape d'élaboration dudit ruban (5) est réalisée par une gravure anisotrope.

4. Procédé selon l'une des revendications précédentes dans lequel la couche de matériau diélectrique (2) comprend de la silice ou du nitrure de silicium ou de l'oxyde d'aluminium ou du nitrure d'aluminium.

5. Procédé selon l'une des revendications précédentes dans lequel la gravure sèche est réalisée avec un plasma comprenant du CHF₃.

6. Procédé selon la revendication 1 dans lequel la gravure sèche spécifique du matériau semi-conducteur (1b) utilise un plasma comprenant du méthane.

7. Procédé selon la revendication 1 dans lequel la quatrième sous-étape de réalisation des bandes métalliques sur la face supérieure de l'empilement comprend :
- une première étape élémentaire de recouvrement de la face supérieure de l'empilement (1) multicouche par un matériau provisoire (3),
- une deuxième étape élémentaire de retrait d'une partie du matériau provisoire (3), le matériau provisoire (3) restant reproduisant le négatif du motif du réseau de diffraction (4) que l'on souhaite produire,
- une troisième étape élémentaire de dépôt d'au moins une couche métallique (9) sur l'ensemble de la face supérieure de l'empilement (1) multicouche,
- une quatrième étape élémentaire de retrait du matériau provisoire (3) recouvert par la couche métallique (9).

8. Procédé selon la revendication 7 dans lequel le matériau provisoire (3) est du poly (methylmethacrylate) ou PMMA.

9. Procédé selon la revendication 2 dans lequel la couche métallique (9) comprend deux sous-couches : une première sous-couche comprenant du titane servant de couche d'accroche et une deuxième sous-couche comprenant du platine.

10. Structure résonante de laser à semi-conducteur à contre-réaction répartie réalisée selon l'une des revendications 1 à 9 dans lequel le ruban (5) présente un plan de symétrie de direction parallèle à la direction de l'empilement (d_{Emp}) multicouche et passant par le milieu de l'ouverture (10).

11. Structure résonante selon la revendication 10 dans laquelle le réseau de diffraction (4) est gravé sur le semi-conducteur (1b) uniquement à l'intérieur de l'ouverture (10).

12. Structure résonante selon la revendication 10 dans laquelle la distance (d₁) selon une direction perpendiculaire (dₚ) à la direction de l'empilement (d_{Emp}) entre une extrémité du réseau de diffraction (4) et la couche de matériau diélectrique (2) est inférieure à 10 nm.

## Patentansprüche

1. Verfahren zur Herstellung einer Resonanzstruktur eines Halbleiterlasers mit verteilter Rückkopplung, wobei die Resonanzstruktur einen mehrschichtigen Stapel (1) aus Halbleitermaterialien (1a; 1b) beinhaltet, wobei der mehrschichtige Stapel (1) mindestens zwei Hohlräume (7) aufweist, welche zwischen den beiden Hohlräumen ein Band (5) an der Oberseite des Stapels (1) definieren, wobei ein Beugungsnetzwerk (4) auf dem Band (5) angeordnet ist, wobei das Verfahren der Reihenfolge nach Folgendes beinhaltet:
- einen ersten Schritt des Herstellens des Bandes (5), Folgendes beinhaltend:
• einen ersten Teilschritt des Bildens der Hohlräume (7),
• einen zweiten Teilschritt des Bedeckens der oberen Seite des Stapels (1) mit einer Schicht aus dielektrischem Material (2),
• einen dritten Teilschritt des Entfernens eines Teils der Schicht aus dielektrischem Material (2) zwischen den Hohlräumen (7) zum Bilden einer Öffnung (10), welche einen Teil des Halbleitermaterials (1b) bloßlegt und als Zugang für den elektrischen Kontakt dient, wobei das Entfernungsverfahren spezifisch für das dielektrische Material (2) ist,
- einen zweiten Schritt des Herstellens des Beugungsnetzwerks (4) innerhalb der Öffnung (10) an dem Band (5), Folgendes beinhaltend:
• einen vierten Teilschritt der Herstellung von Metallbändern, beinhaltend eine Metallschicht (9) an der Oberseite des Stapels (1), wobei die Metallbänder als Maske für die Ätzung des darauffolgenden Teilschrittes dient, wobei die Bänder das Negativ des Musters des Beugungsnetzwerks (4) darstellen, das man erzeugen möchte, und
• einen fünften Teilschritt des Trockenätzens, welcher spezifisch für das Halbleitermaterial (1b) ist.

2. Verfahren nach Anspruch 1, bei welchem das Entfernen mindestens eines Teils des dielektrischen Materials (2) durch für das dielektrische Material spezifisches Trockenätzen erfolgt.

3. Verfahren nach einem der vorhergehenden Ansprüche, bei welchem der erste Teilschritt des Bildens der Hohlräume (7) des ersten Schrittes des Herstellens des Bandes (5) anhand einer anisotropen Ätzung erfolgt.

4. Verfahren nach einem der vorhergehenden Ansprüche, bei welchem die Schicht aus dielektrischem Material (2) Silizium oder Siliziumnitrid oder Aluminiumoxid oder Aluminiumnitrid beinhaltet.

5. Verfahren nach einem der vorhergehenden Ansprüche, bei welchem die Trockenätzung mit einem Plasma erfolgt, welches CHF₃ beinhaltet.

6. Verfahren nach Anspruch 1, bei welchem die für das Halbleitermaterial (1b) spezifische Trockenätzung ein Plasma verwendet, das Methan beinhaltet.

7. Verfahren nach Anspruch 1, bei welchem der vierte Teilschritt des Herstellens von Metallbändern an der oberen Seite des Stapels Folgendes beinhaltet:
- einen ersten Elementarschritt des Bedeckens der oberen Seite des mehrschichtigen Stapels (1) mit einem provisorischen Material (3),
- einen zweiten Elementarschritt des Entfernens eines Teils des provisorischen Materials (3), wobei das verbleibende provisorische Material (3) das Negativ des Musters des Beugungsnetzwerks (4) reproduziert, das man erzeugen möchte,
- einen dritten Elementarschritt des Ablagerns mindestens einer Metallschicht (9) an der gesamten oberen Seite des mehrschichtigen Stapels (1),
- einen vierten Elementarschritt des Entfernens des provisorischen Materials (3), welches durch die Metallschicht (9) bedeckt ist.

8. Verfahren nach Anspruch 7, bei welchem das provisorische Material (3) Poly(methylmethacrylat) oder PMMA ist.

9. Verfahren nach Anspruch 2, bei welchem die Metallschicht (9) zwei Teilschichten beinhaltet: eine erste Teilschicht, welche Titan beinhaltet, welche als Haftschicht dient und eine zweite Teilschicht, welche Platin beinhaltet.

10. Resonanzstruktur eines Halbleiterlasers mit verteilter Rückkopplung, hergestellt nach einem der Ansprüche 1 bis 9, bei welcher das Band (5) eine Symmetrieebene mit einer Richtung parallel zur Richtung des mehrschichtigen Stapels (d_{Emp}) aufweist, welche den Mittelpunkt der Öffnung (10) durchquert.

11. Resonanzstruktur nach Anspruch 10, bei welcher das Beugungsnetzwerk (4) in den Halbleiter (1b) nur innerhalb der Öffnung (10) geätzt ist.

12. Resonanzstruktur nach Anspruch 10, bei welcher der Abstand (d₁) in einer Richtung senkrecht (dₚ) zur Richtung des Stapels (d_{Emp}) zwischen einem Ende des Beugungsnetzwerks (4) und der Schicht aus dielektrischem Material (2) unter 10 nm beträgt.

## Claims

1. The method for producing a resonant structure of a distributed-feedback semiconductor laser, the resonant structure comprising a multilayer stack (1) of semiconducting materials (1a; 1b), the multilayer stack (1) exhibiting at least two cavities (7) defining, between the two cavities, a strip (5) on the upper face of the stack (1), a diffraction grating (4) being disposed on the strip (5), wherein the method comprises, in this order:
- a first step of producing the strip (5) comprising:
• a first sub-step of forming said cavities (7),
• a second sub-step of covering the upper face of the stack (1) with a layer of dielectric material (2),
• a third sub-step of removing part of the layer of dielectric material (2) between said cavities (7) to form an opening (10) exposing a part of the semiconducting material (1b) and serving as access to the electrical contact, the removal procedure being specific to the dielectric material (2),
- a second stage of producing the diffraction grating (4) inside the opening (10) on the strip (5) comprising:
• a fourth sub-step of constructing metal bands comprising a metallic layer (9) on the upper face of the stack (1), the metal bands serving as mask for the etching of the following sub-step, the bands representing the negative of the pattern of the diffraction grating (4) which we wish to produce, and
• a fifth sub-step of specific dry etching of the semiconducting material (1b).

2. The method according to claim 1, wherein the removal of at least a part of the dielectric material (2) is carried out by specific dry etching of the dielectric material.

3. The method according to any one of the preceding claims, wherein the first sub-step of forming said cavities (7) of the first step of producing said strip (5) is carried out by anisotropic etching.

4. The method according to any one of the preceding claims, wherein the layer of dielectric material (2) comprises silica or silicon nitride or aluminum oxide or aluminum nitride.

5. The method according to any one of the preceding claims, wherein the dry etching is carried out with a plasma comprising CHF₃.

6. The method according to claim 1, wherein the specific dry etching of the semiconducting material (1b) uses a plasma comprising methane.

7. The method according to claim 1, wherein the fourth sub-step of constructing the metal bands on the upper face of the stack comprises:
- a first elementary step of covering the upper face of the multilayer stack (1) with a provisional material (3),
- a second elementary step of removing part of the provisional material (3), the remaining provisional material (3) reproducing the negative of the pattern of the diffraction grating (4) which we wish to produce,
- a third elementary step of depositing at least one metallic layer (9) on the whole of the upper face of the multilayer stack (1),
- a fourth elementary step of removing the provisional material (3) covered by the metallic layer (9).

8. The method according to claim 7, wherein the provisional material (3) is poly(methylmethacrylate) or PMMA.

9. The method according to claim 2, wherein the metal layer (9) comprises two sublayers: a first sub-layer comprising titanium serving as binding layer and a second sub-layer comprising platinum.

10. Resonant structure of a distributed-feedback semiconductor laser constructed as claimed in one of claims 1 to 9, wherein the strip (5) exhibits an axis of symmetry with direction parallel to the direction of the multilayer stack (d_{Emp}) and passing through the middle of the opening (10).

11. The resonant structure according to claim 10, wherein the diffraction grating (4) is etched on the semiconductor (1 b) solely inside the opening (10).

12. The resonant structure according to claim 10, wherein the distance (d₁) along a direction (dₚ) perpendicular to the direction of the stack (d_{Emp}) between an end of the diffraction grating (4) and the layer of dielectric material (2) is less than 10 nm.
